# DEMANDE DE BREVET EUROPEEN

(11) **EP 4 390 482 A1**
(43) Date de publication de la demande: **26.06.2024**
(21) Numéro de dépôt: 23219130.4
(22) Date de dépôt: 21.12.2023
(51) Int. Cl.: G02B 6/12, G02B 6/13, H01L 31/0232, H01L 33/06, G02B 6/136, H01L 25/16, H01L 27/15, H01L 31/0352, H01L 33/10, H01L 33/16, H01L 31/105

(54) **SYSTÈME OPTOÉLECTRONIQUE COMPRENANT UN TRANSDUCTEUR ET UN GUIDE D'ONDES**

(30) Priorité: 22.12.2022 FR 2214261
(71) Demandeur: Commissariat à l'énergie atomique et aux énergies alternatives, 75015 Paris (FR)
(72) Inventeur: LE MAITRE, Patrick, 38054 GRENOBLE CEDEX 09 (FR); ROL, Fabian, 38054 GRENOBLE CEDEX 09 (FR); SIMON, Julia, 38054 GRENOBLE CEDEX 09 (FR); MICHIT, Nicolas, 38054 GRENOBLE CEDEX 09 (FR)
(74) Mandataire: Cabinet Camus Lebkiri

(57) **Abrégé**

Un aspect de l'invention concerne un système optoélectronique (1) comportant un transducteur (11) photoélectrique configuré pour émettre ou recevoir des ondes optiques et un guide d'ondes (12) configuré pour guider les ondes émises par le transducteur (11) ou guider les ondes jusqu'au transducteur (11), le système optoélectronique (1) comportant un empilement comprenant successivement :
- une première couche (111) poreuse de matériau semi-conducteur dopé selon un premier type de dopage,
- une deuxième couche (112) de matériau semi-conducteur dopé selon le premier type de dopage et faiblement dopé par rapport au matériau semi-conducteur de la première couche (111),
- une zone (113) comprenant des puits quantiques,
- une troisième couche (116) de matériau semi-conducteur dopé selon un deuxième type de dopage opposé au premier type,

le transducteur (11) photoélectrique comprenant une première portion (111a) de la première couche (111) poreuse, une première portion (112a) de la deuxième couche (112), au moins une première portion (113a) de la zone comprenant le ou les puits quantiques et au moins une première portion (116a) de la troisième couche (116) ;
le guide d'ondes (12) comprenant une deuxième portion (112b) de la deuxième couche (112) adjacente à la première portion (112a) et disposée sur une deuxième portion (111b) de la première couche (111) poreuse.

## Description

### DOMAINE TECHNIQUE DE L'INVENTION

Le domaine technique de l'invention est celui des systèmes photoniques pour la communication intra-puce et inter-puces.

La présente invention concerne un système optoélectronique comprenant un guide d'ondes et un transducteur photoélectrique, des procédés de fabrication du système optoélectronique et des procédés d'intégration du système optoélectronique avec un circuit de contrôle.

### ARRIERE-PLAN TECHNOLOGIQUE DE L'INVENTION

Dans le domaine de la communication inter- puces ou intra-puce, l'utilisation de signaux optiques et notamment de la lumière pour remplacer les signaux électriques permet de surmonter des contraintes physiques liées à l'impédance et la taille des interconnexions métalliques, et ainsi, de répondre au besoin de transférer de grandes quantités de données à très grande vitesse.

Les systèmes ou plateformes photoniques développés à cet effet comprennent une source de lumière, généralement de dimensions micrométriques, excitée électriquement et capable d'être couplée efficacement à un guide d'ondes photonique, lequel conduit la lumière et, ainsi, transporte l'information.

Dans ce contexte, des architectures de diode électroluminescente (ou LED pour « Light Emitting Diode » en anglais), appelés aussi sources LED ou sources micro-LED, ont récemment été utilisées comme source de lumière. Par rapport à des sources lasers, elles ont en effet l'avantage d'être bas-coût et de consommer peu. Il est aussi plus facile de réduire leurs dimensions et ce jusqu'à l'échelle micrométrique.

Les LED permettent par exemple de réaliser des communications dans le visible en champs libre. C'est le principe du LIFI (« Light Fidelity » en anglais) qui est une technologie permettant de transmettre des données à haute vitesse en champs libre, en modulant l'intensité d'une lampe LED. Très récemment, les LED ont également été utilisées pour émettre de la lumière modulée dans une fibre optique pour des interconnexion courtes distances (par exemple des distances de 10 mètres.)

De nouvelles applications se dessinent notamment pour les micro-LED, notamment pour la réalisation de communications visibles haut-débit, et très faible consommation. De nombreux travaux académiques et industriels sont entrepris sur l'utilisation de micro-LED à des fréquences élevées (par exemple 0.1 à 5GHz), à la fois en émission, mais aussi en réception.

L'utilisation de sources LED et notamment micro-LED pose cependant le problème de coupler efficacement la lumière émise dans un guide d'onde.

Afin de réaliser un bon couplage d'une LED, par exemple une LED GaN, dans un guide d'onde, il est nécessaire de maximiser les couplages entre la lumière générée dans la LED et le guide d'onde. Ce couplage est difficile, car la LED émet des modes optiques dans des directions multiples.

En particulier, en couplant une LED à un guide d'onde, il est envisageable de réaliser une liaison inter-puce, de très courte distance et de faible consommation. D'autres technologies pourraient être envisagées, comme la photonique silicium, qui peut fournir des débits d'échanges d'informations très importants sur un même guide.

Cependant, contrairement aux liaisons séries haute-vitesses possibles en photonique silicium, la communication à l'aide de micro-LED ne nécessite pas de sérialisation/désérialisation, très coûteuses en termes de consommation (la vitesse d'un lien série haute-vitesses étant de l'ordre de 25-50Gbit/s contrairement aux communications avec des micro-LED ou la vitesse d'un lien est de l'ordre de quelques Gbit/s) et d'espace, et nécessitant souvent des noeuds technologiques CMOS très avancés, inférieurs à 30nm, et des sources laser externes. Bien que des sources laser InP peuvent être collés sur un substrat en silicium, ce procédé est encore complexe, et coûteux, et réservé à certaines applications haut de gamme.

Il existe donc le besoin de maximiser le couplage entre une LED et notamment une micro-LED avec un guide d'ondes. De manière plus générale, il existe un besoin de maximiser le couplage entre un transducteur photoélectrique et un guide d'ondes.

### RESUME DE L'INVENTION

L'invention offre une solution aux problèmes évoqués précédemment, en permettant de maximiser le couplage entre un transducteur photoélectrique (par exemple une LED) et un guide d'onde.

Un premier aspect de l'invention concerne un système optoélectronique comportant un transducteur photoélectrique configuré pour émettre ou recevoir des ondes optiques et un guide d'ondes configuré pour guider les ondes émises par le transducteur ou guider les ondes jusqu'au transducteur,
ledit système optoélectronique comportant un empilement comprenant successivement :
   - une première couche poreuse de matériau semi-conducteur dopé selon un premier type de dopage,
   - une deuxième couche de matériau semi-conducteur dopé selon le premier type de dopage et faiblement dopé par rapport au matériau semi-conducteur de la première couche,
   - une zone comprenant un ou plusieurs puits quantiques,
   - une troisième couche de matériau semi-conducteur dopé selon un deuxième type de dopage opposé au premier type de dopage,
le transducteur photoélectrique comprenant une première portion de la première couche poreuse, une première portion de la deuxième couche, au moins une première portion de la zone comprenant le ou les puits quantiques et au moins une première portion de la troisième couche ;
le guide d'ondes comprenant une deuxième portion de la deuxième couche adjacente à la première portion et disposée sur une deuxième portion de la première couche poreuse.

Le couplage entre le transducteur et le guide d'ondes est amélioré grâce à la deuxième couche qui est commune au transducteur et au guide d'ondes. En effet, la deuxième couche commune permet d'avoir le même indice de réfraction dans le transducteur et le guide d'ondes, et donc de réduire le nombre de photons réfléchis et perdus. Cependant, un guide d'ondes ne remplit ses fonctions que si un contraste d'indice est possible entre deux matériaux. Pour effectuer ce contraste d'indice, la première couche poreuse a été créé dans le transducteur et s'étend sous le guide d'ondes pour créer un contraste d'indice avec la deuxième couche qui forme au moins une partie du guide d'ondes. Ainsi, le système optoélectronique maximise le couplage entre le guide d'ondes et le transducteur grâce à la deuxième couche commune et à la première couche poreuse.

Outre les caractéristiques qui viennent d'être évoquées dans le paragraphe précédent, le système optoélectronique selon le premier aspect de l'invention peut présenter une ou plusieurs caractéristiques complémentaires parmi les suivantes, considérées individuellement ou selon toutes les combinaisons techniquement possibles :
- la première couche poreuse présente un taux de porosité compris entre 1 % et 80%. L'indice effectif de la première couche poreuse dépend du taux de porosification. Ainsi, il est possible d'ajuster l'indice de la première couche en fonction de taux de porosification et de changer le contraste d'indice entre la première couche et la deuxième couche. En particulier, un contraste d'indice plus fort minimise les pertes par radiation dans les courbures.
- le guide d'ondes comprend en outre une deuxième portion de la zone comprenant le ou les puits quantiques. Avoir une partie du guide d'ondes alignée avec les puits quantiques du transducteur permet de minimiser les pertes de couplage entre le transducteur et le guide d'ondes en maximisant le recouvrement modal entre les deux parties.
- le guide d'ondes comprend en outre une deuxième portion de la troisième couche.
- le premier type de dopage est un dopage N et le second type de dopage est un dopage P ou le premier type de dopage est un dopage P et le second type de dopage est un dopage N.
- le guide d'ondes présente une hauteur comprise entre 200 nm et 300 nm et une largeur comprise entre 200 nm et 300 nm. De telles hauteur et largeur du guide sont adaptées pour obtenir une propagation monomode dans le domaine visible pour les indices optiques considérés. La propagation monomode n'est pas indispensable, mais est souhaitable afin de réaliser des composants photoniques passifs ou actifs, par exemple un diviseur (ou splitter) de puissance ou un coupleur à réseau et de pouvoir propager la lumière dans les guide d'ondes courbés.
- la première couche, la deuxième couche et la troisième couche sont formées du même matériau semi-conducteur, par exemple un matériau III-V, par exemple le nitrure de gallium.
- le transducteur photoélectrique comprend une première électrode en contact électrique avec la deuxième couche et une deuxième électrode en contact électrique avec la troisième couche. Ainsi, le transducteur se distingue du guide d'ondes notamment en ce qu'il comprend des électrodes. Les première et deuxième électrodes ne s'étendent pas dans le guide d'ondes.
- le transducteur photoélectrique est de type diode électroluminescente ou photodiode.
- le système optoélectronique comprend une couche diélectrique enrobant le transducteur photoélectrique et le guide d'ondes.
- le système optoélectronique comprend un miroir disposé sur au moins une surface périphérique du transducteur photoélectrique. L'ajout d'un miroir et/ou d'une couche diélectrique sur au moins une surface périphérique du transducteur, permet de minimiser les pertes vers le substrat.
- le système optoélectronique comprend un miroir de Bragg agencé sous le transducteur et sous le guide d'ondes, ledit miroir comprenant une ou plusieurs couches poreuses de matériau semi-conducteur empilées en alternance avec une ou plusieurs couches de matériau semi-conducteur non poreuses. Le miroir de Bragg minimise les pertes optiques vers le substrat sans avoir d'incidence/effet sur la propagation horizontale des ondes.
- le système optoélectronique comprend un deuxième transducteur photoélectrique, le transducteur et le deuxième transducteur étant disposés de part et d'autre du guide d'ondes, et le deuxième transducteur photoélectrique comporte :
   - une troisième portion de la première couche poreuse,
   - une troisième portion de la deuxième couche,
   - une troisième portion de la zone comprenant le ou les puits quantiques,
   - une troisième portion de la troisième couche.
- le deuxième transducteur photoélectrique est de type diode électroluminescente ou photodiode et de type distinct du transducteur photoélectrique.

Un deuxième aspect de l'invention concerne un procédé de fabrication du système optoélectronique selon le premier aspect de l'invention, le procédé comprenant :
- La formation d'un empilement en faisant croitre successivement par épitaxie, sur un substrat, une couche de matériau semi-conducteur dopé selon le premier type de dopage, la deuxième couche de matériau semi-conducteur la zone comprenant le ou les puits quantiques, et la troisième couche de matériau semi-conducteur,
- La porosification de la couche de matériau semi-conducteur dopé selon le premier type de dopage, pour obtenir la première couche de semi-conducteur poreuse,
- La gravure partielle d'au moins la troisième couche de matériau semi-conducteur, pour délimiter le guide d'ondes, et obtenir une première zone de motifs non gravée ,
- La gravure partielle de l'empilement jusqu'à la deuxième couche de matériau semi-conducteur, de manière à délimiter latéralement le transducteur dans la première zone de motifs,

Outre les caractéristiques qui viennent d'être évoquées dans le paragraphe précédent, le procédé selon le deuxième aspect de l'invention peut présenter une ou plusieurs caractéristiques complémentaires parmi les suivantes, considérées individuellement ou selon toutes les combinaisons techniquement possibles :
- l'étape de gravure partielle d'au moins la troisième couche de matériau semi-conducteur est accomplie de manière à délimiter en outre une deuxième zone de motifs non gravée, la première et la deuxième zones de motifs étant disposées de part et d'autre du guide d'onde,
- l'étape de gravure partielle de l'empilement jusqu'à la deuxième couche de matériau semi-conducteur est accomplie de manière à délimiter en outre latéralement le deuxième transducteur dans la deuxième zone de motifs .
- Le procédé selon le deuxième aspect de l'invention comprend la formation
   - d'une première électrode en contact électrique avec la première portion de la troisième couche ,
   - d'une deuxième électrode en contact électrique avec la première portion de la deuxième couche ,
   - d'une troisième électrode en contact électrique avec la troisième portion de la troisième couche , et de préférence,
   - d'une quatrième électrode en contact électrique avec la troisième portion de la deuxième couche .

Un troisième aspect de l'invention concerne un procédé de fabrication du système optoélectronique selon le premier aspect de l'invention, le procédé comprenant :
- La formation d'un empilement en faisant croitre successivement par épitaxie, sur un substrat, une couche en matériau semi-conducteur dopé selon le premier type de dopage et la deuxième couche de matériau semi-conducteur dopée selon le premier type de dopage et faiblement dopée par rapport à la première couche ,
- La gravure partielle de la deuxième couche de matériau semi-conducteur, de manière à obtenir un ilot,
- La porosification de la couche en matériau semi-conducteur dopé selon le premier type de dopage, pour obtenir la première couche de matériau semi-conducteur poreuse,
- la formation , par épitaxie sélective, de la zone comprenant le ou les puits quantiques sur une première région de l'ilot,
- la formation par épitaxie sélective de la troisième couche de matériau semi-conducteur sur la zone comprenant le ou les puits quantiques dans la première région, de manière à former le transducteur dans la première région,
- Selon un mode de réalisation :
   - l'étape de formation par épitaxie sélective de la zone comprenant le ou les puits quantiques est accomplie simultanément sur une deuxième région de l'ilot, distincte de la première région ,
   - l'étape de formation par épitaxie sélective de la troisième couche de matériau semi-conducteur est accomplie simultanément dans la deuxième région de l'ilot de manière à former le deuxième transducteur dans la deuxième région de l'ilot,
- le procédé selon le troisième aspect de l'invention comprend la formation :
   - d'une première électrode en contact électrique avec la première portion de la troisième couche et appartenant au transducteur,
   - d'une deuxième électrode en contact électrique avec la deuxième couche , la deuxième électrode étant de préférence commune au transducteur et au deuxième transducteur ;
   - d'une troisième électrode en contact avec la troisième portion de la troisième couche et appartenant au deuxième transducteur.

Un quatrième aspect de l'invention concerne un procédé d'intégration d'un système optoélectronique selon le premier aspect de l'invention avec un circuit de contrôle intégré, le procédé comprenant :
- la formation d'un empilement en faisant croitre successivement par épitaxie, sur un substrat , une couche de matériau semi-conducteur dopé selon le premier type de dopage, la deuxième couche , la zone comprenant le ou les puits quantiques, et la troisième couche de matériau semi-conducteur,
- la porosification de la couche de matériau semi-conducteur dopée selon le premier type de dopage, pour obtenir la première couche de matériau semi-conducteur poreuse,
- la gravure partielle d'au moins la troisième couche , pour délimiter le guide d'ondes , et obtenir une première zone de motifs et une deuxième zone de motifs , la première zone de motifs et la deuxième zone de motifs étant disposées de part et d'autre du guide d'ondes ,
- le dépôt d'une couche diélectrique sur le guide d'ondes ;
- le dépôt d'une première couche métallique sur la couche diélectrique et la troisième couche dans la première zone de motifs et la deuxième zone de motifs ,
- le dépôt d'une deuxième couche métallique sur une première face d'un substrat receveur, le substrat receveur comprenant le circuit de contrôle ,
- le collage de la première couche métallique et de la seconde couche métallique ,
- le retrait du substrat
- la gravure partielle de la première zone de motifs de manière à délimiter le transducteur et de la deuxième zone de motifs de manière à délimiter le deuxième transducteur,
- la formation :
   - d'une première électrode sur la première portion de la deuxième couche,
   - d'une deuxième électrode sur la troisième portion de la deuxième couche ,
   - d'une troisième couche métallique sur une deuxième face opposée du substrat receveur , la troisième couche métallique étant reliée à la deuxième couche métallique formant une troisième électrode commune au transducteur et au deuxième transducteur .

Un cinquième aspect de l'invention concerne un procédé d'intégration d'un système optoélectronique selon le premier aspect de l'invention avec un circuit de contrôle, le procédé comprenant :
- la fabrication du système optoélectronique selon le premier aspect de l'invention, en accomplissant les étapes du procédé de fabrication selon le deuxième ou troisième aspect de l'invention;
- la formation sur l'empilement d'un niveau de collage hybride comprenant une première électrode en contact électrique avec première portion de la troisième couche , la première électrode appartenant au transducteur, et une deuxième électrode en contact électrique avec la troisième portion de la troisième couche , la deuxième électrode appartenant au deuxième transducteur, les première et deuxième électrodes étant entourées d'une couche diélectrique , de manière à obtenir une surface plane avec les première et deuxième électrodes ;
- le collage hybride de l'empilement avec un substrat récepteur comprenant le circuit de contrôle , le circuit de contrôle comportant une pluralité de plots de connexion entourés d'une couche diélectrique , de sorte que la première électrode et la deuxième électrode soient collées aux plots de connexion du circuit de contrôle, et de sorte que la couche diélectrique de l'empilement soit collée à la couche diélectrique du circuit de contrôle ,
- le retrait du substrat,
- la gravure partielle:
   - Au sein du transducteur : de la première portion de la première couche poreuse jusqu'à la deuxième couche, pour obtenir une première ouverture,
   - Au sein du deuxième transducteur : de la troisième portion de la première couche poreuse jusqu'à la deuxième couche, pour obtenir une deuxième ouverture ;
- La formation d'une troisième électrode dans les première et deuxième ouvertures, la troisième électrode étant commune au transducteur et au deuxième transducteur, et connexion de la troisième électrode à l'un des plots de connexion du circuit de contrôle .

L'invention et ses différentes applications seront mieux comprises à la lecture de la description qui suit et à l'examen des figures qui l'accompagnent.

### BREVE DESCRIPTION DES FIGURES

Les figures sont présentées à titre indicatif et nullement limitatif de l'invention.
[Fig. 1] est une vue en coupe d'un mode de réalisation d'un système optoélectronique selon un premier aspect de l'invention,
Les [Fig. 2], et [Fig. 3] représentent des variantes du mode de réalisation de la [Fig. 1],
[Fig. 4] est une vue de dessus de la variante de la [Fig.3],
Les [Fig. 5], [Fig. 6], [Fig. 7] et [Fig. 8] représentent d'autres variantes du mode de réalisation de la [Fig. 1],
La [Fig. 9] est une vue du dessus d'un mode de réalisation du système optoélectronique,
Les [Fig. 10a], [Fig. 10b], [Fig. 10c], [Fig. 10d] et [Fig. 10e] sont des étapes d'un procédé de fabrication du système optoélectronique selon un deuxième aspect de l'invention.
Les [Fig. 11a], [Fig. 11b], [Fig. 11c], [Fig. 11d], [Fig. 11e] et [Fig. 11f] sont des étapes d'un procédé de fabrication du système optoélectronique selon un troisième aspect de l'invention.
Les [Fig. 12a], [Fig. 12b], [Fig. 12c], [Fig. 12d], [Fig. 12e], [Fig. 12f], [Fig. 12g], [Fig. 12h], [Fig. 12i] et [Fig. 12j] sont des étapes d'un procédé d'intégration du système optoélectronique selon un quatrième aspect de l'invention.
Les [Fig. 13a], [Fig. 13b], [Fig. 13c], [Fig. 13d] et [Fig. 13e] sont des étapes d'un procédé d'intégration du système optoélectronique selon un cinquième aspect de l'invention.

### DESCRIPTION DETAILLEE

Les figures sont présentées à titre indicatif et nullement limitatif de l'invention.

Un premier aspect de l'invention concerne un système optoélectronique.

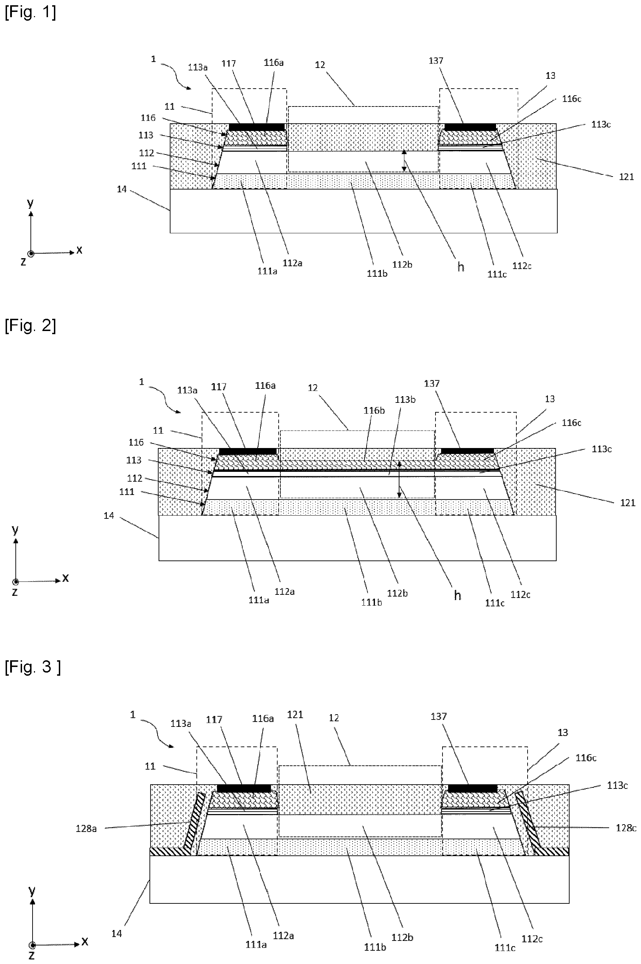

La [Fig. 1] montre une représentation schématique en coupe d'un premier mode de réalisation du système optoélectronique 1. Le système optoélectronique 1 comporte un transducteur photoélectrique 11, configuré pour émettre ou recevoir des ondes optiques, et un guide d'ondes 12 configuré pour guider les ondes émises par le transducteur 11 ou pour guider les ondes reçues jusqu'au transducteur 11. Le transducteur 11 est par exemple une diode électroluminescente ou une photodiode.

Le système optoélectronique 1 comporte, de préférence sur un substrat 14, un empilement, comprenant successivement : une première couche 111 poreuse de matériau semi-conducteur dopé selon un premier type de dopage, une deuxième couche 112 de matériau semi-conducteur dopé selon le premier type de dopage et faiblement dopé par rapport au matériau semi-conducteur de la première couche 111, une zone 113 comprenant un ou plusieurs puits quantiques et une troisième couche 116 de matériau semi-conducteur dopé selon un deuxième type de dopage. La deuxième couche 112 de matériau semi-conducteur est cependant suffisamment dopée pour qu'une jonction P-N soit réalisable.

Le matériau semi-conducteur est par exemple un matériau semi-conducteur III-V ou un matériau semi-conducteur II-VI.

Un matériau semi-conducteur III-V est formé par exemple à partir d'un alliage binaire tel que le nitrure de bore (BN), le phosphure de bore (BP), l'arséniure de bore (BAs), nitrure d'aluminium (AIN), le phosphure d'aluminium (AIP), l'arséniure d'aluminium (AlAs), l'antimoniure d'aluminium (AlSb), le phosphure de gallium (GaP), l'arséniure de gallium (GaAs), l'antimoniure de gallium (GaSb), le Nitrure d'indium (InN), le phosphure d'indium (InP), l'arséniure d'indium (InAs), l'antimoniure d'indium (InSb) ou de préférence le nitrure de Gallium (GaN). Un matériau III-V peut également être un matériau semi-conducteur formé à partir d'un alliage ternaire tel que le nitrure de gallium-indium (InGaN), le nitrure d'aluminium-gallium (AIGaN), le phosphure de gallium-indium (InGaP), etc.

Un matériau semi-conducteur II-VI est par exemple formé à partir de tellurure de cadmium (CdTe) ou le sulfure de cadmium (CdS). Avantageusement, le CdTe et le CdS sont des semi-conducteurs émetteurs de lumière efficaces.

Plus généralement, le matériau semi-conducteur formant chaque couche du système optoélectronique 1 est capable d'émettre de la lumière.

Le substrat 14 peut comprendre une couche de support, appelée aussi support de croissance, par exemple formée de silicium ou de saphir, et une couche tampon formée par exemple de nitrure de gallium et disposée sur la couche de support.

Le premier type de dopage (ou type de conductivité) est opposé au deuxième type de dopage. Par exemple, le premier type de dopage est un dopage de type N et le deuxième type de dopage est un dopage de type P. Alternativement, le premier type de dopage est un dopage de type P et le deuxième type de dopage est un dopage de type N.

Le transducteur 11 photoélectrique comprend une première portion 111a de la première couche 111 poreuse, une première portion 112a de la deuxième couche 112, une première portion 113a de la zone 113 comprenant le ou les puits quantiques et une première portion 116a de la troisième couche 116.

Le guide d'ondes 12 comprend une deuxième portion 112b de la deuxième couche 112 adjacente à la première portion 112a et disposée sur une deuxième portion 111b de la première couche 111 poreuse. Autrement dit, la deuxième couche 112 s'étend au-delà du transducteur 11 pour former au moins une partie du guide d'ondes 12. En outre, la première couche 111 s'étend au-delà du transducteur 11 et est disposée sous le guide d'ondes 12. En particulier, la deuxième portion 112b de la deuxième couche 112 forme le coeur du guide d'ondes 12.

La première couche 111, la deuxième couche 112 et la troisième couche 116 sont avantageusement formées du même matériau semi-conducteur, par exemple le nitrure de galium (GaN). Un même matériau semi-conducteur facilite la fabrication du système optoélectronique 1.

Selon un mode de réalisation préféré, la troisième couche 116 est formée de GaN dopé P, la zone 113 comprend un ou plusieurs puits quantiques InGaN/(GaN (émettant dans le rouge,le vert ou le bleu par exemple), la deuxième couche 112 est formée de GaN dopé N et la première couche 111 est formée à partir de GaN fortement dopé N.

Le matériau semi-conducteur de la première couche 111 est fortement dopé par rapport au matériau semi-conducteur de la deuxième couche 112. Autrement dit, la concentration en impuretés dopantes de la première couche 111 est par exemple supérieure ou égale à 5 fois la concentration en impuretés dopantes de la deuxième couche 112. Par exemple, la concentration en impuretés dopantes de la première couche 111 est de l'ordre de 10¹⁹ atomes/cm³ et la concentration en impuretés dopantes de la deuxième couche 112 est de l'ordre 10¹⁷ atomes/cm³.

Le couplage entre le transducteur 11 et le guide d'ondes est amélioré grâce au fait que la deuxième couche s'étend de façon continue dans le transducteur 11 et dans le guide d'ondes 12. En effet, la deuxième couche 112 permet d'avoir le même indice de réfraction dans le transducteur 11 et le guide d'ondes 12. Si l'indice de réfraction du transducteur 11 est différent de l'indice de réfraction du guide d'ondes 12, les ondes lumineuses peuvent être injectées dans le guide par le transducteur, mais un plus grand nombre de photons sera réfléchi (en fonction des angles d'incidence) et sera donc perdu.

Cependant, un guide d'ondes ne remplit ses fonctions que si un contraste d'indice est possible entre deux matériaux. Ce contraste d'indice est ici obtenu entre la première couche poreuse 111 et la deuxième couche 112.

Notons n₁₁₁ l'indice de réfraction du matériau semi-conducteur formant la première couche 111 poreuse et nair l'indice de l'air. L'indice de réfraction de la première couche 111 poreuse est égal à neff = [(1- ϕ)n₁₁₁² + ϕ nₐᵢᵣ²]1/2, avec ϕ le taux de porosité de la première couche 111 poreuse.

En particulier, ϕ est compris entre 1% et 80%, par exemple compris entre 20% et 80%, et en particulier entre 40% et 80% ou entre 20% et 70% . En particulier, ϕ est de préférence égal à 20%. Un taux de porosité égal à 20% permet par exemple d'obtenir le guide d'ondes 12 avec un contraste d'indice de 3 entre la première couche 111 poreuse et la deuxième couche 112.

La plus grande dimension (la hauteur) des pores de la première couche 111 peut varier de quelques nanomètres à quelques micromètres. La plus petite dimension (le diamètre) peut varier de quelques nanomètres à une centaine de nanomètres, en particulier de 10 nm à 70 nm, par exemple de 30 nm à 70 nm, et de préférence de 15 nm à 40 nm.

Dans le mode de réalisation de la figure 1, la hauteur h du guide d'ondes 112 est égale à l'épaisseur de la deuxième couche, de préférence comprise entre 200nm et 350nm.

Le transducteur 11 comprend en outre une première électrode 117, en contact électrique avec la première portion 116a de la troisième couche 116, et une deuxième électrode (non représentée sur la figure 1), en contact électrique avec la première portion 112a de la deuxième couche 112.

La première électrode 117 est de préférence disposée sur la première portion 116a de la troisième couche 116 et en contact direct avec celle-ci. Elle peut recouvrir toute la face supérieure de la première portion 116a de la troisième couche 116, étant donné qu'une émission/réception verticale de la lumière n'est pas souhaitée.

Contrairement à la deuxième couche 112, les première et deuxième électrodes ne s'étendent pas dans le guide d'ondes 12. Le guide d'ondes 12 est dépourvu d'électrode.

La [Fig. 2] représente une variante du mode de réalisation de la [Fig. 1].

Le guide d'ondes 12 comprend en plus une deuxième portion 113b de la zone 113 comprenant le ou les puits quantiques et une deuxième portion 116b de la troisième couche 116. La deuxième portion 116b de la troisième couche 116 peut être amincie, c'est-à-dire présenter une épaisseur inférieure à celle de la première portion 116a de la troisième couche 116.

Ainsi, la zone 113 comprenant le ou les puits quantiques s'étend au-delà du transducteur 11 pour former une partie du guide d'ondes 12 et la troisième couche 116 s'étend au-delà du transducteur 11 pour former également une partie du guide d'ondes 12.

Cela a pour effet d'améliorer encore le couplage entre le transducteur 11 et le guide d'ondes 12, car le recouvrement modal entre la partie guide et transducteur est amélioré.

Les puits quantiques dans le guide d'ondes n'absorbent qu'une partie négligeable de la lumière, grâce au déplacement de Stokes (« Stoke shift » en anglais qui traduit le décalage de longueur d'onde entre le pic d'absorption et le pic d'émission (la longueur d'onde d'absorption est plus petite que la longueur d'onde d'émission). En diminuant la taille du guide d'ondes 12 en hauteur et largeur (pour aller vers une propagation monomode), les contraintes mécaniques et le champ électrique interne sont diminuées, ce qui augmente déplacement de Stokes. La hauteur est définie selon l'axe y, et la largeur selon l'axe z.

Dans cette variante de réalisation, la hauteur h du guide d'ondes est de préférence comprise entre 200 nm et 300 nm.

Selon une variante de la [Fig. 1] non représentée, le guide d'ondes comprend, en plus de la deuxième portion 112b de la deuxième couche 112, uniquement la deuxième portion 113b de la zone 113 comprenant le ou les puits quantiques.

D'une manière commune à tous les modes et variantes de réalisation, le système optoélectronique 1 peut comprendre un deuxième transducteur 13 photoélectrique, configuré pour émettre ou recevoir des ondes optiques, le guide d'ondes 12 étant également configuré pour guider les ondes émises par le deuxième transducteur 13 ou pour guider les ondes jusqu'au deuxième transducteur 13. Le deuxième transducteur 13 est par exemple une diode électroluminescente ou une photodiode.

De préférence, le deuxième transducteur 13 est de type différent du transducteur 11. Par type, on désigne le caractère émetteur ou récepteur du transducteur, donc diode électroluminescente ou photodiode. Ainsi, l'un des transducteurs 11 et 13 est en mode émission (LED) et l'autre des transducteurs 11 et 13 est en mode réception (photodiode).

Le deuxième transducteur 13 comprend une troisième portion 111c de la première couche poreuse 111, c'est-à-dire que la première couche poreuse 111 s'étend au-delà du premier transducteur 11 et du guide d'ondes 12 pour former une partie du deuxième transducteur 13.

Le deuxième transducteur comprend en outre une troisième portion 112c de la deuxième couche 112, c'est-à-dire que la deuxième couche 112 s'étend au-delà du premier transducteur 11 et du guide d'ondes 12 pour former une partie du deuxième transducteur 13.

Le deuxième transducteur 13 comprend une troisième portion 113c de la zone 113 comprenant la ou les puits quantiques et une troisième portion 116c de la troisième couche 116.

Dans le mode de réalisation de la [Fig. 1], la troisième portion 113c de la zone 113 est distincte (c.-à-d. séparée) de la première portion 113a de la zone 113 et la troisième portion 112c de la deuxième couche 112 est distincte de la première portion 112a de la deuxième couche 112. A l'inverse, dans la variante de la [Fig. 2], la deuxième portion 113b de la zone 113 est adjacente aux première et troisième portions 113a et 113c de la zone 113 et la deuxième portion 112b de la deuxième couche 112 est adjacente aux première et troisième portions 112a et 112c de la deuxième couche 112.

Le deuxième transducteur 13 comprend en outre une troisième électrode 137 en contact électrique avec la troisième portion 116c de la troisième couche 116. La troisième électrode 137 est de préférence disposée sur la troisième portion 116c de la troisième couche 116 et en contact direct avec celle-ci.

En l'absence du deuxième transducteur 13, le transducteur 11 peut comprendre la totalité de la zone 113 et la totalité de la troisième couche 116.

Le système optoélectronique 1 peut comprendre en outre une couche diélectrique 121 enrobant le transducteur 11, le guide d'ondes 12 et, le cas échant, le deuxième transducteur 13. La couche diélectrique 121 forme de préférence une surface plane avec les électrodes 117, 137 du transducteur 11 et du deuxième transducteur 13. La couche diélectrique 121 est par exemple formée d'oxyde d'aluminium (ou alumine, Al₂O₃).

Selon un mode de réalisation représenté à la [Fig. 3], le système optoélectronique 1 comprend un premier miroir, ou structure réfléchissante 128a situé sur une ou plusieurs surfaces périphériques du transducteur 11 et, le cas échéant, un deuxième miroir 128c situé sur une ou plusieurs surfaces périphériques du deuxième transducteur 13. De préférence, les premier et deuxième miroirs 128a-128c sont formés chacun d'une couche métallique. Les deux couches métalliques sont de préférence formées du même métal, par exemple de l'aluminium.

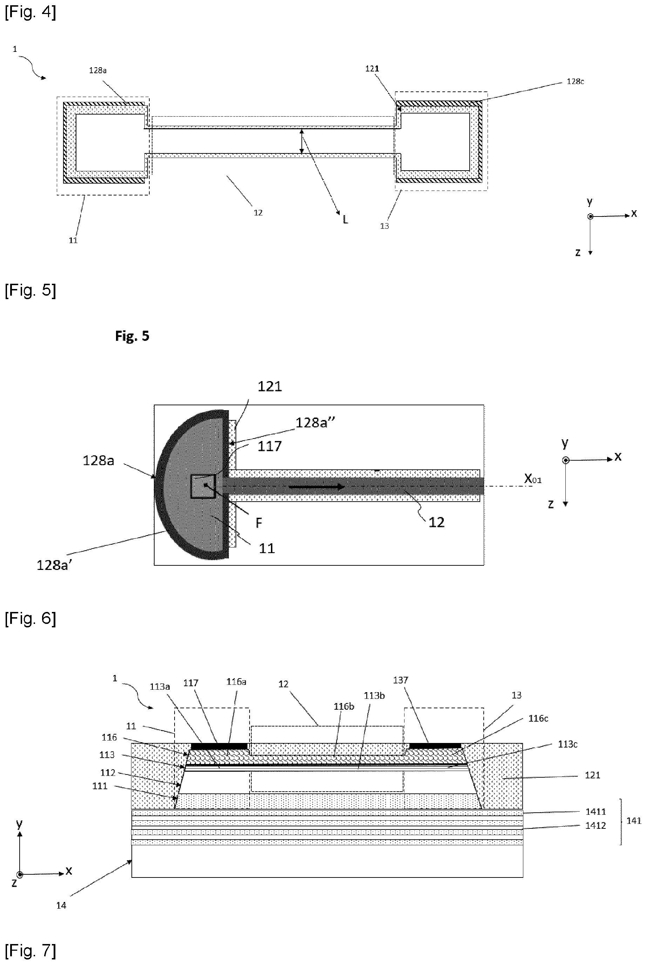

La [Fig. 4] est une vue du dessus du système optoélectronique 1 selon la [Fig. 3]. Cette figure montre la couche diélectrique 121 entourant le transducteur 11, le guide d'ondes 12 et le deuxième transducteur 13, le premier miroir 128a disposé sur plusieurs faces latérales du transducteur 11 et séparé de celles-ci par la couche diélectrique 121, et le deuxième miroir 128c disposé sur plusieurs faces latérales du deuxième transducteur 13 et séparé de celles-ci par la couche diélectrique 121.

La disposition de la couche diélectrique 121, du premier miroir 128a et, le cas échant, du deuxième miroir 128c favorise le couplage de la lumière des transducteurs dans le guide d'ondes (dans le cas d'un transducteur de type LED) et/ou la réception de la lumière par l'autre transducteur (dans le cas d'un transducteur de type photodiode) en réduisant les pertes de rayons lumineux.

Toujours en référence à la figure 4, la largeur L (définie selon l'axe z) du guide d'ondes 12 (sans la couche diélectrique 121) est de préférence inférieure à la largeur du transducteur 11 (et la largeur du deuxième transducteur 13), par exemple comprise entre 200 nm et 300 nm.

Dans une variante de réalisation représentée par la [Fig.5], le premier miroir 128a est de forme cylindro-parabolique d'axe y. Le transducteur 11 (comprenant l'empilement de couches) épouse la forme du premier miroir 128a et présente donc une première surface latérale également de forme cylindro-parabolique. La première électrode 117 du transducteur 11 est située à la verticale d'une partie au moins des foyers F du premier miroir 128a. En particulier, le premier miroir 128a est un cylindre droit tronqué, d'axe et de génératrices perpendiculaires au plan (X, Z) du substrat 14, et admettant pour courbe directrice une parabole d'axe X₀₁ parallèle au plan du substrat 10 et ayant pour foyer le point F situé sur l'axe X₀₁, le cylindre droit étant tronqué par un plan parallèle aux génératrices et passant par le foyer F. Le premier miroir 128a est ainsi délimité par une surface cylindrique comprenant une surface latérale parabolique 128a' et une surface latérale plane 128a".

La couche diélectrique 121 qui enrobe le guide d'onde 12 recouvre au moins une deuxième surface latérale opposée au premier miroir 128a. Elle peut également s'étendre, comme décrit précédent, entre le transducteur 11 et le premier miroir 128a, comme décrit précédemment en relation avec la figure 4.

Ainsi, lorsque le transducteur 11 est une LED, les ondes émises par le transducteur 11 et reçues par le premier miroir 128a sont concentrées dans le guide d'onde 12. Inversement, lorsque le transducteur 11 est une photodiode, les ondes provenant du guide d'ondes 12 et reçues par le premier miroir 128a sont concentrées dans le transducteur 11.

La [Fig. 6] est une variante de réalisation du système optoélectronique 1 dans laquelle le substrat 14 comprend un miroir de Bragg 141, de préférence directement en contact avec la première couche 111 poreuse. En particulier, le miroir de Bragg 141 (autrement appelé miroir poreux) comprend une ou plusieurs couches poreuses 1411 de matériau semi-conducteur empilées en alternance avec une ou plusieurs couches non poreuses 1412 de matériau semi-conducteur. Lorsque le transducteur 11 est une diode électroluminescente, le miroir de Bragg 141 permet de minimiser les pertes vers le substrat 14, sans avoir d'incidence sur la propagation de la lumière dans le guide d'ondes 12.

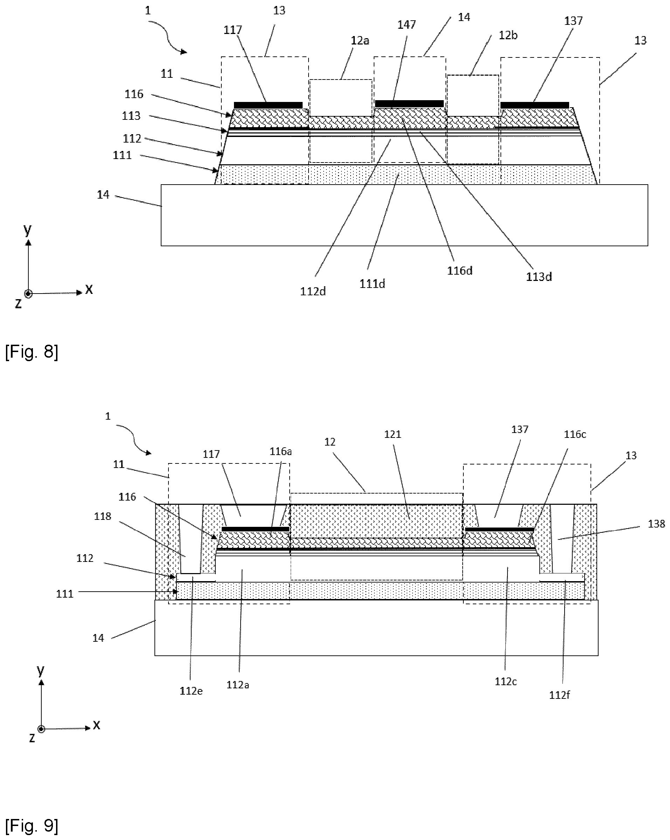

La [Fig. 7] est une variante de réalisation du système optoélectronique 1 dans laquelle le système optoélectronique 1 comprend un troisième transducteur 14 et dans laquelle le guide d'ondes 12 comprend une première portion 12a et une deuxième portion 12b disposées de part et d'autre du troisième transducteur 14. En particulier, le troisième transducteur 14 comprend une quatrième portion 111d de la première couche 111, une quatrième portion 112d de la deuxième couche 112, une quatrième portion 113d de la zone 113 comprenant le ou les puits quantiques et une quatrième portion 116d de la troisième couche 116. En outre, le troisième transducteur 14 comprend une électrode 147 disposée sur la quatrième portion 116d de la troisième couche 116. L'électrode 147 du troisième transducteur 14 ne s'étend pas au-delà du troisième transducteur 14.

Le troisième transducteur 14 est de préférence une diode électroluminescente, située sur le chemin optique des ondes guidées par le guide d'onde 12. Celle-ci a pour rôle de changer l'indice de propagation des ondes ou de moduler la puissance desdites ondes (fonction modulateur), en appliquant une polarisation (« bias » en anglais) qui permet d'absorber la lumière se propageant dans le guide d'ondes 12 et traversant le troisième transducteur 14.

La [Fig. 8] montre un arrangement possible des électrodes du système optoélectronique 1, compatible avec tous les modes de réalisations décrits précédemment.

Outre la première électrode 117 disposée sur la première portion 116a de la troisième couche 116, le transducteur 11 comprend une deuxième électrode 118 disposée sur une première portion en retrait 112e de la deuxième couche 112. La première portion en retrait 112e est adjacente à la première portion 112a.

Par ailleurs, outre la troisième électrode 137 disposée sur la troisième portion 116c de la troisième couche 116, le deuxième transducteur 13 peut comprendre une quatrième électrode 138 disposée sur une deuxième portion en retrait 112f de la deuxième couche 112. La deuxième portion en retrait 112f est adjacente à la troisième portion 112c.

La quatrième électrode 138 n'est pas obligatoire, étant donné que le contact électrique avec la deuxième couche 112 est déjà assuré par la deuxième électrode 118 et que la deuxième couche 112 s'étend de façon continue jusqu'au deuxième transducteur 13. Toutefois, elle améliore la distribution de courant dans la deuxième transducteur (on parle aussi d'injection électrique dans le cas d'une LED).

Les première et deuxième portions en retrait 112e-112f de la deuxième couche 112 sont de préférence formées par gravure partielle de la deuxième couche 112.

De préférence, aucune des électrodes ne s'étend au-delà du transducteur 11 ou au-delà du deuxième transducteur 13 dans le guide d'ondes 12.

Lorsque la deuxième couche 112 est dopée N et la troisième couche 116 est dopée P, la première électrode 117 est l'anode du transducteur 11, la deuxième électrode 118 est la cathode du transducteur 11, la troisième électrode 137 est la cathode du deuxième transducteur 13 et la quatrième électrode 138 est l'anode du deuxième transducteur 13.

Selon un autre arrangement, la deuxième électrode 118 et/ou la quatrième électrode 138 est disposée en contact avec une face inférieure de la deuxième couche 112 et s'étend par conséquent à travers la première couche 111 poreuse.

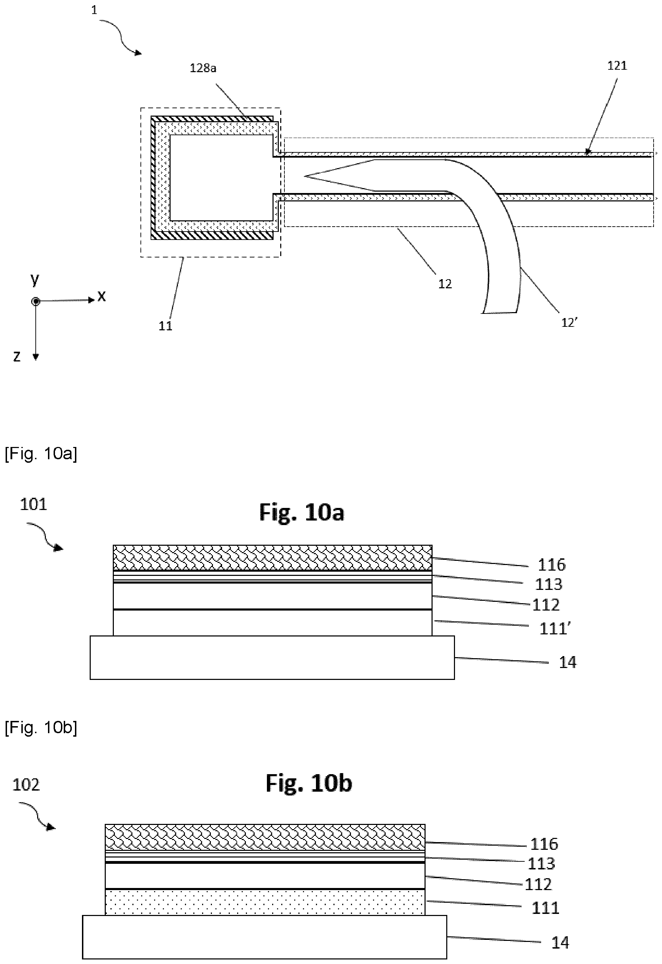

La [Fig. 9] représente en vue de dessus un autre mode de réalisation du système optoélectronique 1 dans lequel un second guide d'ondes 12' est couplé au premier guide d'ondes 12, de préférence par couplage évanescent. Le second guide d'ondes est de préférence en SiN, AIN ou Al₂O₃ et permet, par exemple, de propager les ondes lumineuses émises par le transducteur 11 et se propageant dans le guide d'ondes 12. Le deuxième guide 12', qui s'étend par exemple perpendiculairement au premier guide 12, propagent les ondes avec moins de pertes que le premier guide 12. Le couplage évanescent occasionne peu de pertes.

Un deuxième aspect de l'invention concerne un procédé 100 de fabrication du système optoélectronique 1 selon le premier aspect de l'invention.

Une première étape 101 du procédé 100, représentée à la [Fig. 10a], est une étape de formation d'un empilement, en faisant croitre successivement par épitaxie sur le substrat 14 une couche 111' de matériau semi-conducteur fortement dopé selon le premier type de dopage, la deuxième couche 112 de matériau semi-conducteur, la zone 113 comprenant le ou les puits quantiques, et la troisième couche 116 de matériau semi-conducteur.

Une deuxième étape 102 du procédé 100, représentée à la [Fig. 10b], est une étape de porosification de la couche 111' pour obtenir la première couche 111 poreuse. La porosification est par exemple accomplie par un procédé électrochimique: la couche 111' est plongée dans une solution et une différence de potentiel est appliquée entre la couche 111' et la solution , ce qui aboutit à la formation de pores dans la couche 111'. Lors de la porosification, la couche 111' fortement dopée joue le rôle d'anode et un fil de platine peut jouer le rôle de cathode. La porosification, dite porosification électrochimique, est par exemple réalisée dans une solution d'acide oxalique (0,2M) en appliquant une tension de 15V pendant 30min,

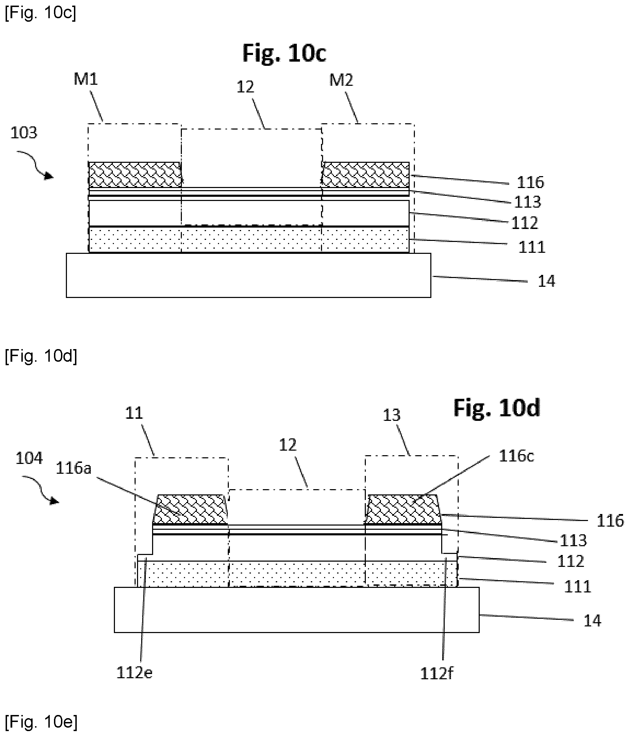

Une troisième étape 103 du procédé 100, représentée à la [Fig. 10c], est une étape de gravure partielle d'au moins la troisième couche 116, pour délimiter le guide d'ondes 12, et obtenir une première zone de motifs M1 non gravée.

La troisième couche 116 peut être gravée de préférence, sur toute son épaisseur, donc jusqu'à la zone 113 comprenant le ou les puits quantiques pour former la première portion 116a et la troisième portion 116c de la troisième couche 116, la couche 116c n'étant pas formée dans ce cas. Ce mode de réalisation préférentiel permet d'isoler électriquement la première zone de motifs M1 et la deuxième zone de motifs M2 jusqu'au puit quantique de faible dimension. En particulier, l'épaisseur de la zone 13 comprenant un ou plusieurs puits quantiques est égale ou sensiblement égale à 100 nm.

La troisième couche 116 peut également être gravée sur une partie seulement de son épaisseur, pour former la première portion 116a, la deuxième portion 116b et la troisième portion 116c.

La zone 113 comprenant le ou les puits quantiques peut être également gravée, à la suite de la troisième couche 116 (selon la composition souhaitée du guide d'ondes 12).

Comme cela est représenté par la [Fig. 10d], l'étape de gravure partielle d'au moins la troisième couche 116 peut délimiter en outre une deuxième zone de motifs M2 non gravée, la première et la deuxième zone de motifs M1, M2 étant disposées de part et d'autre du guide d'ondes 12.

A l'issue de l'étape 103, la première portion 116a et la troisième portion 116c de la troisième couche 116 sont obtenues.

Une quatrième étape 104 du procédé 100 est une étape de gravure 104 partielle de l'empilement jusqu'à la deuxième couche 112, de manière à délimiter latéralement le transducteur 11 dans la première zone de motifs M1. De préférence, la première portion en retrait 112e de la deuxième couche 112 est formée simultanément.

Lorsque la zone de motifs M2 a été délimitée à la troisième étape 103, la gravure de l'empilement accomplie à la quatrième étape 104 peut délimiter en outre, latéralement, le deuxième transducteur 13 dans la deuxième zone de motifs M2. La deuxième portion en retrait 112f de la deuxième couche 112 est de préférence formée simultanément.

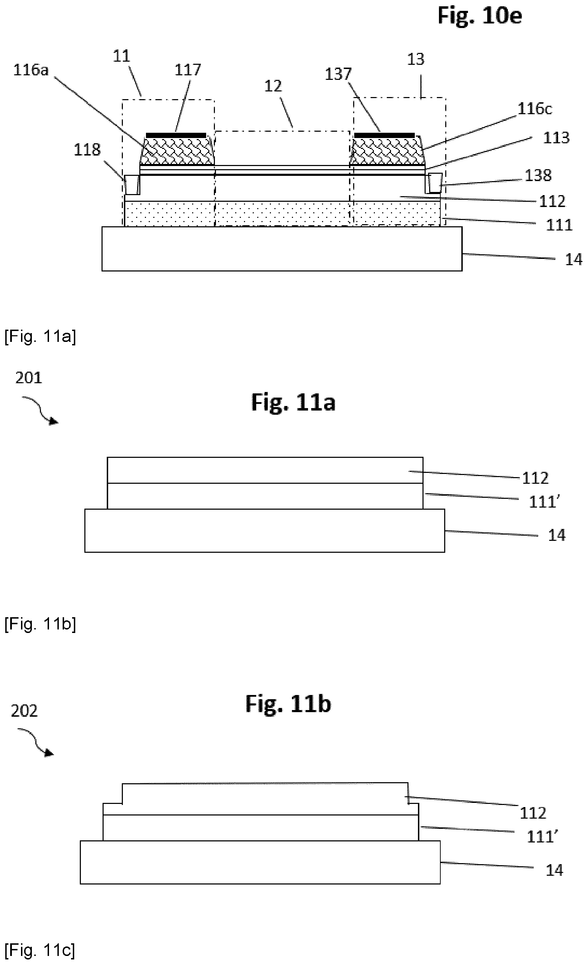

Une cinquième étape 105 du procédé, représentée à la [Fig. 10e], est une étape de formation de la première électrode 117 et la deuxième électrode 118 du transducteur 11 La troisième électrode 137 et la quatrième électrode 138 du deuxième transducteur 13 peuvent être également formées au cours de cette cinquième étape 105. Les électrodes 117-118, 137-138 sont telles que décrites en référence à la figure 8.

La deuxième étape 102 de porosification de la couche 111' de matériau semi-conducteur fortement dopé peut être réalisée avant ou après les troisième 103 et quatrième 104 étapes du procédé 100. La porosification peut également être accomplie immédiatement après la croissance de la couche 111' de matériau semi-conducteur fortement dopé, avant la croissance des autres couches de l'empilement.

Un troisième aspect de l'invention concerne un procédé 200 de fabrication du système optoélectronique 1 selon le premier aspect de l'invention.

Une première étape 201 du procédé 200, représentée à la [Fig.11a], est une étape de formation d'un empilement, sur le substrat 14, en faisant croitre successivement par épitaxie une couche 111' en matériau semi-conducteur dopée selon le premier type de dopage et la deuxième couche 112 de matériau semi-conducteur dopée selon le premier type de dopage et faiblement dopée par rapport à la première couche 111.

Une deuxième étape 202 du procédé 200, représentée à la [Fig. 11b], est une étape de gravure partielle de la deuxième couche 112, de manière à obtenir un ilot (aussi appelé « mesa »). La gravure sert notamment à définir la marque qui servira à former une électrode, mais également à la formation de la mésa qui passe au travers de la couche 111' pour pouvoir la porosifier ensuite, sinon l'électrolyte permettant la porosification n'a pas accès à la couche 111'.

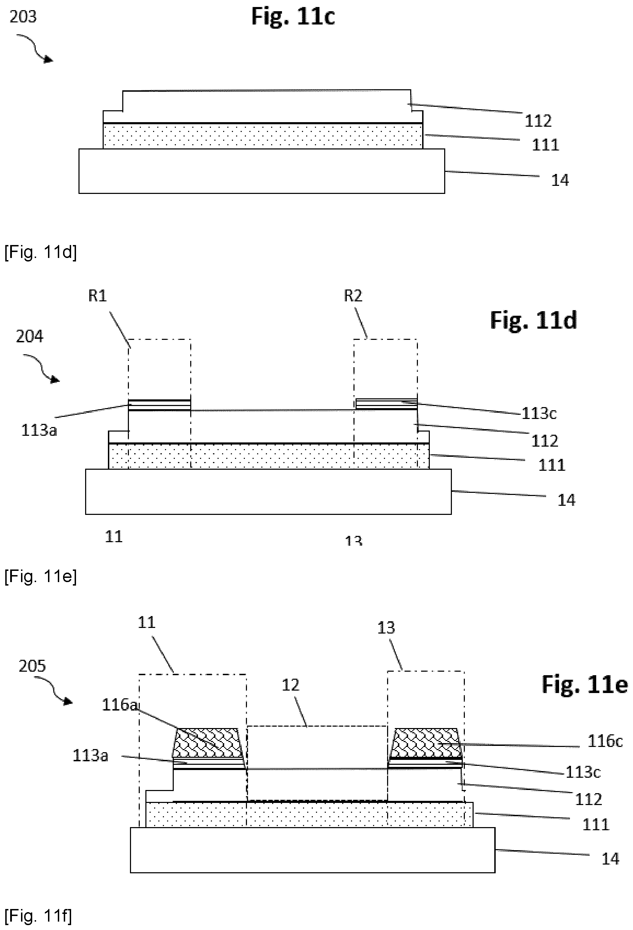

Une troisième étape 203 du procédé 200, représentée à la [Fig. 11c] est une étape de porosification de la couche 111' en matériau conducteur dopée selon le premier type de dopage pour obtenir la première couche 111 poreuse. En particulier, la troisième étape 203 du procédé est accomplie de manière identique à la deuxième étape 102 de porosification du procédé 100 selon le deuxième aspect de l'invention.

Une quatrième étape 204 du procédé 200, représentée à la [Fig.11d], est une étape de formation par épitaxie sélective, de la zone 113 comprenant le ou les puits quantiques sur une première région R1 de l'ilot. En particulier, la quatrième étape 204 permet de former la première portion 113a de la zone 113.

Selon un mode de réalisation, la quatrième étape 204 est accomplie simultanément sur une deuxième région R2 de l'îlot, distincte de la première région R1. La troisième portion 113c de la zone 113 est ainsi formée.

En particulier, la région R1 et la région R2 ont été délimitées par un masque dur pour permettre la croissance par épitaxie sélective de la première portion 113a et de la troisième portion 113c de la zone 113.

Une cinquième étape 205 du procédé 200, représentée à la [Fig. 11e], est une étape de formation de la troisième couche 116 de matériau semi-conducteur sur la zone 113 comprenant le ou les puits quantiques dans la première région R1, de manière à former le transducteur 11 dans la première région R1. En particulier, la cinquième étape 205 permet de former la première portion 116a de la troisième couche 116.

Selon un mode de réalisation, la cinquième étape 205 de formation par épitaxie sélective de la troisième couche 116 de matériau semi-conducteur est accomplie simultanément dans la deuxième région R2 de l'ilot de manière à former la troisième portion 116c de la troisième couche 116 et ainsi former le deuxième transducteur 13 dans la deuxième région R2 de l'ilot.

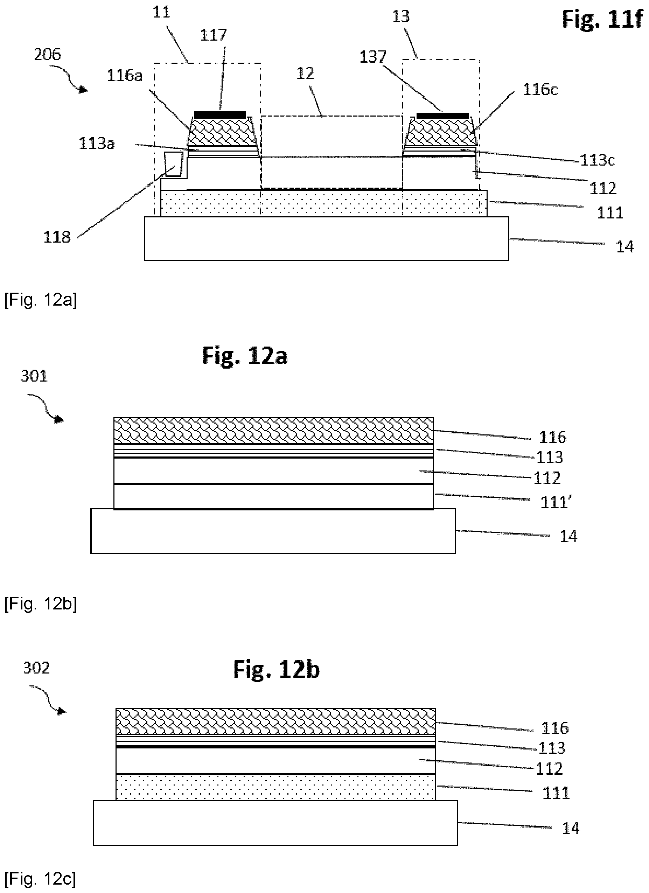

Une sixième étape 206 du procédé 206, représentée à la [Fig.11f], est une étape de formation d'une première électrode 117 sur la première portion 116a de la troisième couche 116, d'une deuxième électrode 118 sur une portion en retrait de la deuxième couche 112 (en dehors de l'ilot) et une troisième électrode 137 sur la troisième portion 116c de la troisième couche 116.

La première électrode 117 est en contact électrique avec la première portion 116a de la troisième couche 116 et appartient ainsi au transducteur 11, tandis que la troisième électrode 137' est en contact électrique avec la troisième portion 116c de la troisième couche 116 et appartient ainsi au deuxième transducteur 13.

La deuxième électrode 118 est ici commune au transducteur 11 et au deuxième transducteur 13. Alternativement, le procédé 200 peut comprendre, à la sixième étape 206, la formation d'une quatrième électrode 138 en contact électrique avec la deuxième couche 112, sur une deuxième portion en retrait de la deuxième couche 112 (en dehors de l'ilot).

Un quatrième aspect de l'invention concerne un procédé 400 d'intégration d'un système optoélectronique 1 selon le premier aspect de l'invention avec un circuit de contrôle des transducteurs (LED et photodiodes). Le circuit de contrôle est par exemple de type ASIC (acronyme de l'anglais « application-specific integrated circuit »).

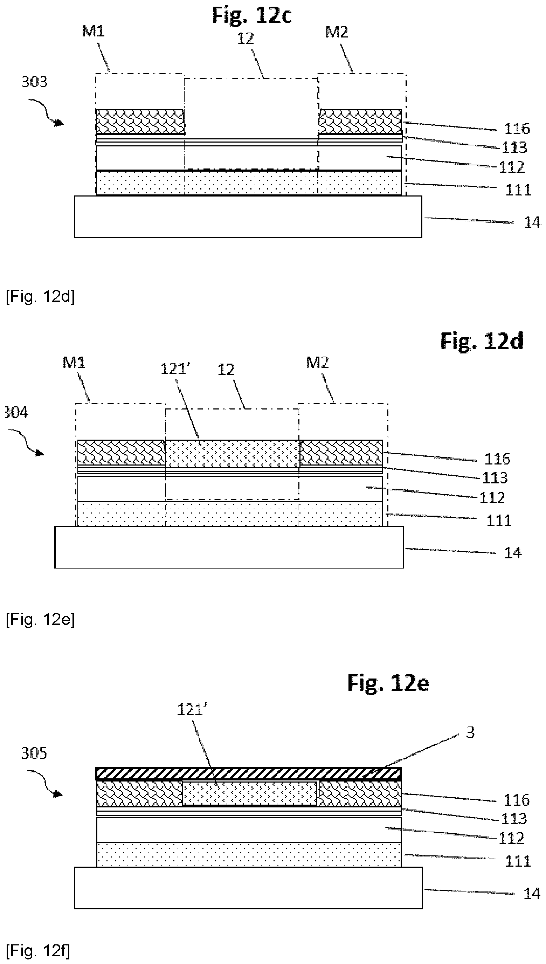

Les trois premières étapes 301 à 303 du procédé 300, représentées par les [Fig. 12a], [Fig. 12a] et [Fig. 12c] sont identiques aux étapes 101 à 103 du procédé 100 (Figs.10a-10c).

Une quatrième étape 304 du procédé 300, représentée à la [Fig.12d], est une étape de dépôt d'une couche diélectrique 121' sur le guide d'ondes 12.

Une cinquième étape 305 du procédé 300, représentée à la [Fig.12e], est une étape de dépôt d'une première couche métallique 3 sur la couche diélectrique 121' et la troisième couche 116 dans la première zone de motifs M1 et la deuxième zone de motifs M2. La première couche métallique 3 forme ainsi une première électrode (anode ou cathode selon le type de dopage de la troisième couche 116) commune entre le transducteur 11 et le deuxième transducteur 13.

La première couche métallique 3 peut comprendre une première sous-couche dite barrière en TaN, TiN, WN, TiW, ou en une combinaison d'un ou plusieurs de ces matériaux et une deuxième sous-couche dite de collage en Ti, Ni, Pt, Sn, Au, Ag, Al, Pd, W, Pb, Cu, AuSn, TiSn, NiSn ou en un alliage de tout ou partie de ces matériaux. La sous-couche barrière est disposée sur la couche diélectrique 121' et la troisième couche 116, et la sous-couche de collage est disposée sur la sous-couche barrière.

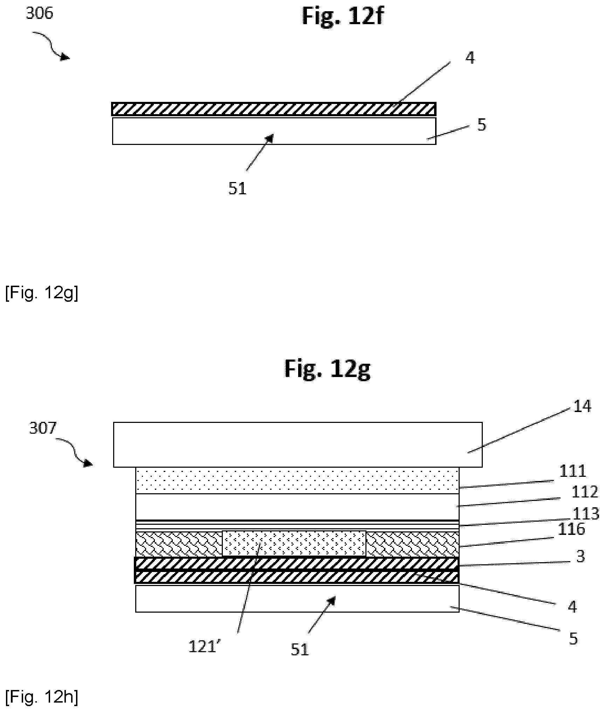

Une sixième étape 306 du procédé 300, représentée à la [Fig.12f], est une étape de dépôt d'une deuxième couche métallique 4 sur une première face d'un substrat receveur 5, le substrat receveur 5 comprenant un circuit de contrôle 51. Le circuit de contrôle 51 peut notamment comporter une pluralité de plots de connexion (non représentés) reliés électriquement à la deuxième couche métallique 4.

À titre d'exemple, le substrat receveur 5 est dit « actif », c'est-à-dire que le substrat 5 comprend des composants électroniques actifs tels que des transistors. Le substrat 5 est par exemple de type CMOS (de l'anglais « Complementary Metal-Oxide-Semiconductor » - métal-oxyde-semi-conducteur complémentaire) ou de type TFT (de l'anglais « Thin-Film Transistor » - transistor en couches minces).

A l'instar de la première couche métallique 3, la deuxième couche métallique 4 peut comprendre une sous-couche barrière en TaN, TiN, WN, TiW, ou en une combinaison d'un ou plusieurs de ces matériaux et une sous-couche de collage en Ti, Ni, Pt, Sn, Au, Ag, Al, Pd, W, Pb, Cu, AuSn, TiSn, NiSn ou en un alliage de tout ou partie de ces matériaux.

Une septième étape 307 du procédé 300, représentée à la [Fig.12g], est une étape de collage de la première couche métallique 3 et de la seconde couche métallique 4, de sorte que la troisième couche 116 de l'empilement soit électriquement connectée au circuit de contrôle 51. Le collage métal-métal permet de s'affranchir d'une étape d'alignement précis entre les plots de connexion du circuit de contrôle 51 et les transducteurs 11,13 lors de l'étape d'assemblage du système optoélectronique 1 avec le circuit de contrôle 51, cette étape d'alignement étant généralement difficile à réaliser, notamment pour des transducteurs dont les dimensions sont inférieures à 1 µm.

Le collage est par exemple un collage moléculaire, un collage par thermocompression, un collage eutectique, ou toute autre méthode de fixation adaptée.

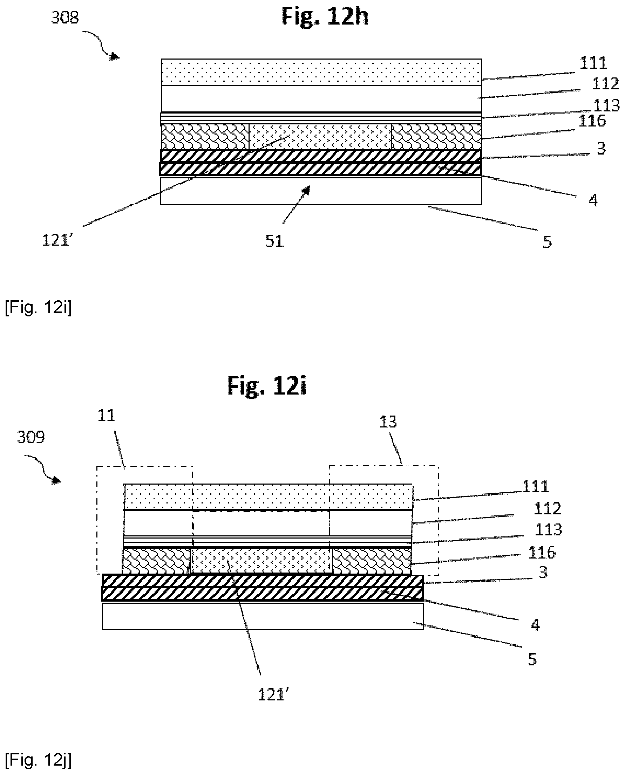

Une huitième étape 308 du procédé 300, représentée à la [Fig.12h], est une étape de retrait 308 du substrat 14, le retrait étant réalisé par gravure ou polissage mécano-chimique (CMP) par exemple.

Une neuvième étape 309 du procédé 300, représentée à la [Fig.12i], est une étape de gravure partielle de la première zone de motifs M1 de manière à délimiter latéralement le transducteur 11 et de la deuxième zone de motifs M2 de manière à délimiter latéralement le deuxième transducteur 12. L'accomplissement de la neuvième étape 309 de gravure après la septième étape 307 de collage permet de définir une électrode commune pour le transducteur 11 et le deuxième transducteur 13, ladite électrode commune étant formée de la première couche métallique 3 et de la seconde couche métallique 4, le pilotage individuel de chacun des transducteurs parmi le transducteur 11 et le deuxième transducteur 13 étant réalisé par l'électrode 118' pour le transducteur 11 et l'électrode 138' pour le deuxième transducteur13 .

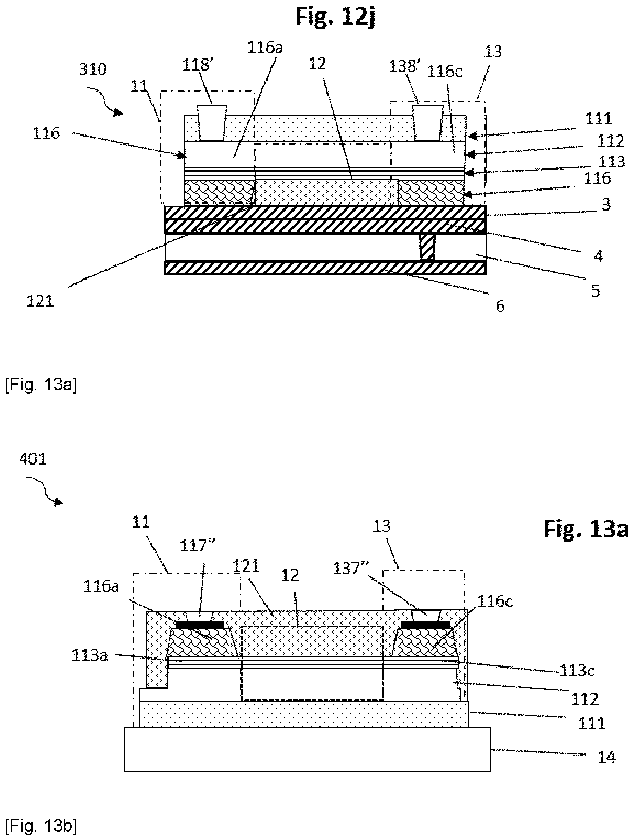

Une dixième étape 310 du procédé 300, représentée à la [Fig.12j], est une étape de formation d'une deuxième électrode 118' et d'une troisième électrode 138' en contact électrique avec la troisième couche 116 et d'une troisième couche métallique 6 sur une deuxième face opposée du substrat receveur 5.

La première électrode 118' s'étend à travers la première portion 111a de la première couche 111 poreuse et appartient au transducteur 11.

La deuxième électrode 138' s'étend à travers la troisième portion 111c de la première couche 111 poreuse et appartient au deuxième transducteur 13.

La troisième couche métallique 6 est reliée électriquement à la deuxième couche métallique 4 par un ou plusieurs via traversant le substrat receveur 5.

Un cinquième aspect de l'invention concerne un procédé 400 d'intégration du système optoélectronique 1 selon le premier aspect de l'invention avec un circuit de contrôle.

Le procédé 400 d'intégration du système optoélectronique 1 débute par la fabrication du système optoélectronique 1 comprenant le transducteur 11, le guide d'ondes 12 et le deuxième transducteur 13. Pour ce faire, les étapes 101 à 104 du procédé de fabrication 100 ou les étapes 201 à 205 du procédé de fabrication 200 sont avantageusement accomplies.

En référence à la [Fig. 13a], le procédé 400 comprend ensuite une étape 401 de formation d'un niveau de collage hybride (métal-diélectrique) sur l'empilement, et plus particulièrement le guide d'ondes 12 et la troisième couche 116. Le niveau de collage hybride comprend une première électrode 117" en contact électrique avec la première portion 116a de la troisième couche 116 et une deuxième électrode 137" en contact avec la troisième portion 116c de la troisième couche 116.

Le niveau de collage hybride comprend également une couche diélectrique 121 entourant la première électrode 117" et la deuxième électrode 137". La couche diélectrique 121 forme une surface plane avec la face supérieure des première et deuxième électrodes 117", 137".

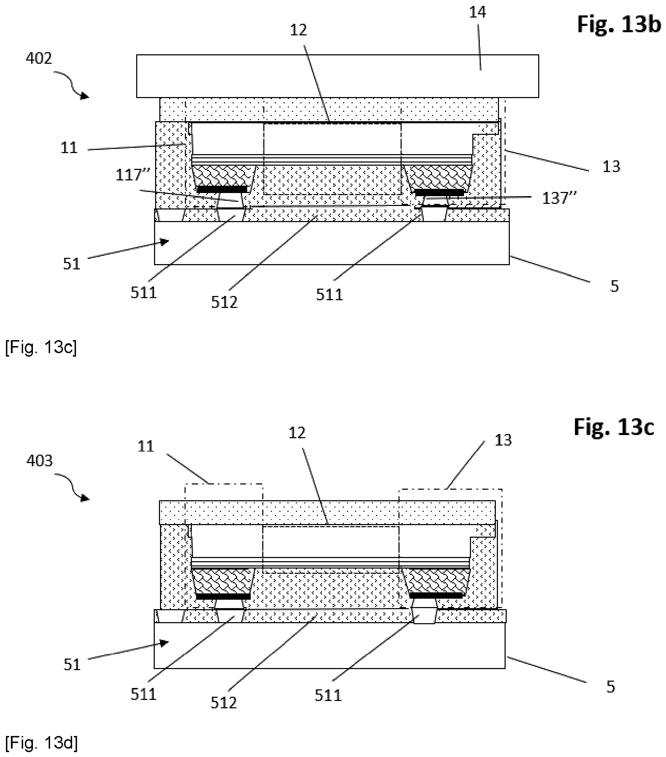

En référence à la [Fig. 13b], le procédé 400 comprend ensuite une étape 402 de collage hybride de l'empilement avec un substrat récepteur 5 comprenant le circuit de contrôle 51.

En particulier, le subtrat récepteur 5 comporte une pluralité de plots de connexion 511 de connexion entourés d'une couche diélectrique 512. La première électrode 117" et la deuxième électrode 137" sont amenées en contact et collés avec les plots de connexion 511 du circuit de contrôle, et la couche de diélectrique 121 de l'empilement est disposée en contact et collée à la couche diélectrique 512 recouvrant le substrat receveur 5.

En référence à la [Fig. 13c], le procédé 400 comprend ensuite une étape 403 de retrait du substrat 14, par gravure ou CMP par exemple.

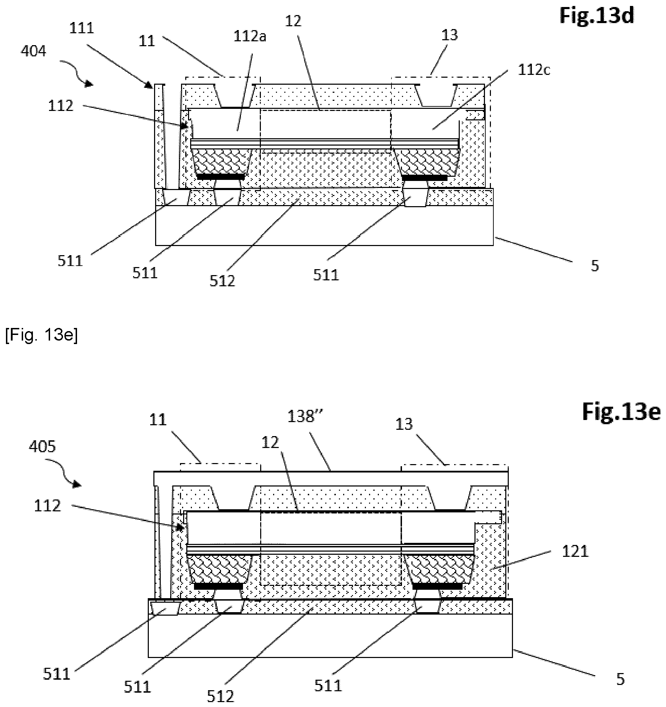

En référence à la [Fig. 13d], le procédé 400 comprend ensuite une étape 404 de gravure partielle de la première couche 111 poreuse, de sorte à obtenir une première ouverture qui débouche sur la première portion 112a de la deuxième couche 112 (donc dans le transducteur 11) et une deuxième ouverture qui débouche sur la troisième portion 112c de la deuxième couche 112 (donc dans le deuxième transducteur 13).

Enfin, la [Fig. 13e] représente une étape 405 de formation d'une troisième électrode 138" dans les première et deuxième ouvertures et sur la première couche 111 poreuse, de préférence par dépôt d'un métal, l'électrode 138" étant ainsi commune au transducteur 11 et au deuxième transducteur 13.

La troisième électrode 138" est avantageusement connectée à un plot métallique 511 du circuit de contrôle 51. Cette connexion est avantageusement réalisée en formant une troisième ouverture qui s'étend à travers la première couche 111 poreuse et la couche diélectrique 121 enrobant le transducteur 11, le guide d'onde 12 et le deuxième transducteur 13, puis en remplissant cette troisième ouverture du métal.

## Revendications

1. Système optoélectronique (1) comportant un transducteur (11) photoélectrique configuré pour émettre ou recevoir des ondes optiques et un guide d'ondes (12) configuré pour guider les ondes émises par le transducteur (11) ou guider les ondes jusqu'au transducteur (11),
ledit système optoélectronique (1) comportant un empilement comprenant successivement :
- une première couche (111) poreuse de matériau semi-conducteur dopé selon un premier type de dopage,
- une deuxième couche (112) de matériau semi-conducteur dopé selon le premier type de dopage et faiblement dopé par rapport au matériau semi-conducteur de la première couche (111),
- une zone (113) comprenant un ou plusieurs puits quantiques,
- une troisième couche (116) de matériau semi-conducteur dopé selon un deuxième type de dopage opposé au premier type de dopage,
le transducteur (11) photoélectrique comprenant une première portion (111a) de la première couche (111) poreuse, une première portion (112a) de la deuxième couche (112), au moins une première portion (113a) de la zone comprenant le ou les puits quantiques et au moins une première portion (116a) de la troisième couche (116) ;
le guide d'ondes (12) comprenant une deuxième portion (112b) de la deuxième couche (112) adjacente à la première portion (112a) et disposée sur une deuxième portion (111b) de la première couche (111) poreuse.

2. Système optoélectronique (1) selon la revendication précédente **caractérisé en ce que** la première couche (111) poreuse présente un taux de porosité compris entre 1% et 80%.

3. Système optoélectronique (1) selon la revendication précédente **caractérisé en ce que** le guide d'ondes (12) comprend en outre une deuxième portion (113b) de la zone (113) comprenant le ou les puits quantiques.

4. Système optoélectronique (1) selon la revendication précédente **caractérisé en ce que** le guide d'ondes (12) comprend en outre une deuxième portion (116b) de la troisième couche (116).

5. Système optoélectronique (1) selon l'une quelconque des revendications précédentes **caractérisé en ce que** le guide d'ondes (12) a une hauteur (h) comprise entre 200 nm et 300 nm et une largeur (L) comprise entre 200 nm et 300 nm.

6. Système optoélectronique (1) selon l'une quelconque des revendications précédentes **caractérisé en ce que** la première couche (11), la deuxième couche (112) et la troisième couche (116) sont formées du même matériau semi-conducteur, par exemple un matériau III-V, par exemple le nitrure de gallium.

7. Système optoélectronique (1) selon l'une quelconque des revendications précédentes **caractérisé en ce que** le transducteur (11) photoélectrique est de type diode électroluminescente ou photodiode.

8. Système optoélectronique (1) selon l'une quelconque des revendications précédentes **caractérisé en ce qu'**il comprend en outre une couche diélectrique (121) enrobant le transducteur (11) photoélectrique et le guide d'ondes (12).

9. Système optoélectronique (1) selon l'une quelconque des revendications précédentes **caractérisé en ce qu'**il comprend un miroir (128a) disposé sur au moins une surface périphérique du transducteur (11) photoélectrique.

10. Système optoélectronique (1) selon l'une quelconque des revendications précédentes **caractérisé en ce qu'**il comprend un miroir de Bragg (141) agencé sous le transducteur (11) et sous le guide d'ondes (12), ledit miroir (141) comprenant une ou plusieurs couches poreuses (1411) de matériau semi- conducteur empilées en alternance avec une ou plusieurs couches (1412) de matériau semi-conducteur non poreuses.

11. Système optoélectronique (1) selon l'une quelconque des revendications précédentes **caractérisé en ce qu'**il comprend un deuxième transducteur (13) photoélectrique, le transducteur (11) et le deuxième transducteur (13) étant disposés de part et d'autre du guide d'ondes (12), et **en ce que** le deuxième transducteur (13) photoélectrique comporte :
- une troisième portion (111c) de la première couche (111) poreuse,
- une troisième portion (112c) de la deuxième couche (112),
- une troisième portion (113c) de la zone (113) comprenant le ou les puits quantiques,
- une troisième portion (116c) de la troisième couche (116).

12. Système optoélectronique (1) selon la revendication précédente **caractérisé en ce que** le deuxième transducteur photoélectrique est de type diode électroluminescente ou photodiode et de type distinct du premier transducteur photoélectrique.

13. Procédé (100) de fabrication du système optoélectronique (1) selon l'une quelconque des revendications 1 à 12, **caractérisé en ce qu'**il comprend :
- la formation (101) d'un empilement en faisant croitre successivement par épitaxie, sur un substrat (14), une couche (111') de matériau semi-conducteur dopé selon le premier type de dopage, la deuxième couche (112) de matériau semi-conducteur la zone (113) comprenant le ou les puits quantiques, et la troisième couche (116) de matériau semi-conducteur,
- la porosification (102) de la couche (111') de matériau semi-conducteur dopé selon le premier type de dopage, pour obtenir la première couche (111) de semi-conducteur poreuse,
- la gravure (103) partielle d'au moins la troisième couche (116) de matériau semi-conducteur, pour délimiter le guide d'ondes (12), et obtenir une première zone de motifs (M1) non gravée,
- la gravure (104) partielle de l'empilement jusqu'à la deuxième couche (112) de matériau semi-conducteur, de manière à délimiter latéralement le transducteur (11) dans la première zone de motifs (M1),

14. Procédé (100) selon la revendication précédente, permettant de fabriquer le système optoélectronique (1) selon l'une des revendications 11 et 12 **caractérisé en ce que** :
- l'étape de gravure (103) partielle d'au moins la troisième couche (116) de matériau semi-conducteur est accomplie de manière à délimiter en outre une deuxième zone de motifs (M2) non gravée, la première (M1) et la deuxième (M2) zones de motifs étant disposées de part et d'autre du guide d'onde,
- l'étape de gravure (104) partielle de l'empilement jusqu'à la deuxième couche (112) de matériau semi-conducteur est accomplie de manière à délimiter en outre latéralement le deuxième transducteur (13) dans la deuxième zone de motifs (M2).

15. Procédé (100) selon l'une des revendications 13 et 14 **caractérisé en ce qu'**il comprend la formation (105) :
- d'une première électrode (117) en contact électrique avec la première portion (116a) de la troisième couche (116),
- d'une deuxième électrode (118) en contact électrique avec la première portion (112a) de la deuxième couche (112),
- d'une troisième électrode (137) en contact électrique avec la troisième portion (116c) de la troisième couche (116), et de préférence,
- d'une quatrième électrode (138) en contact électrique avec la troisième portion (112c) de la deuxième couche (112).

16. Procédé (200) de fabrication d'un système optoélectronique, le système optoélectronique étant selon l'une des revendications 1 à 12, le procédé comprenant :
- la formation (201) d'un empilement en faisant croitre successivement par épitaxie, sur un substrat (14), une couche (111') en matériau semi-conducteur dopé selon le premier type de dopage et la deuxième couche (112) de matériau semi-conducteur dopée selon le premier type de dopage et faiblement dopée par rapport à la première couche (111),
- la gravure (202) partielle de la deuxième couche (112) de matériau semi-conducteur, de manière à obtenir un ilot,
- la porosification (203) de la couche (111') en matériau semi-conducteur dopé selon le premier type de dopage, pour obtenir la première couche (111) de matériau semi-conducteur poreuse,
- la formation (204), par épitaxie sélective, de la zone (113) comprenant le ou les puits quantiques sur une première région de l'ilot,
- la formation (205) par épitaxie sélective de la troisième couche (116) de matériau semi-conducteur sur la zone (113) comprenant le ou les puits quantiques dans la première région, de manière à former le transducteur (11) dans la première région (R1).

17. Procédé (200) selon la revendication précédente **caractérisé en ce que** :
- l'étape de formation (204) par épitaxie sélective de la zone (13) comprenant le ou les puits quantiques est accomplie simultanément sur une deuxième région (R2) de l'ilot, distincte de la première région (R1),
- l'étape de formation (205) par épitaxie sélective de la troisième couche (116) de matériau semi-conducteur est accomplie simultanément dans la deuxième région (R2) de l'ilot de manière à former le deuxième transducteur (13) dans la deuxième région de l'ilot.

18. Procédé selon la revendication précédente **caractérisé en ce qu'**il comprend la formation (206) :
- d'une première électrode (117) en contact électrique avec la première portion (116a) de la troisième couche (116) et appartenant au transducteur (11),
- d'une deuxième électrode (118) en contact électrique avec la deuxième couche (112), la deuxième électrode (118) étant de préférence commune au transducteur (11) et au deuxième transducteur (13) ;
- d'une troisième électrode (137) en contact avec la troisième portion (116c) de la troisième couche (116) et appartenant au deuxième transducteur (13).

19. Procédé (300) d'intégration d'un système optoélectronique (1) selon l'une des revendications 11 à 12 avec un circuit de contrôle (51), le procédé comprenant :
- la formation (301) d'un empilement en faisant croitre successivement par épitaxie, sur un substrat (14), une couche (111') de matériau semi-conducteur dopé selon le premier type de dopage, la deuxième couche (112), la zone (113) comprenant le ou les puits quantiques, et la troisième couche (116) de matériau semi-conducteur,
- la porosification (302) de la couche (111') de matériau semi-conducteur dopée selon le premier type de dopage, pour obtenir la première couche (111) de matériau semi-conducteur poreuse,
- la gravure (303) partielle d'au moins la troisième couche (116), pour délimiter le guide d'ondes (12), et obtenir une première zone de motifs (M1) et une deuxième zone de motifs (M2), la première zone de motifs (M1) et la deuxième zone de motifs (M2) étant disposées de part et d'autre du guide d'ondes (12),
- le dépôt (304) d'une couche diélectrique (121) sur le guide d'ondes (12) ;
- le dépôt (305) d'une première couche métallique (3) sur la couche diélectrique et la troisième couche (116) dans la première zone de motifs (M1) et la deuxième zone de motifs (M2),
- le dépôt (306) d'une deuxième couche métallique (4) sur une première face d'un substrat receveur (5), le substrat receveur (5) comprenant le circuit de contrôle (51),
- le collage (307) de la première couche métallique (3) et de la seconde couche métallique (4),
- le retrait (308) du substrat (14),
- la gravure (309) partielle de la première zone de motifs (M1) de manière à délimiter le transducteur (11) et de la deuxième zone de motifs (M2) de manière à délimiter le deuxième transducteur (12),
- la formation (310) :
∘ d'une première électrode (118') sur la première portion (112a) de la deuxième couche (112),
∘ d'une deuxième électrode (138') sur la troisième portion (112c) de la deuxième couche (112),
∘ d'une troisième couche métallique (6) sur une deuxième face opposée du substrat receveur (5), la troisième couche métallique (6) étant reliée à la deuxième couche métallique (4) formant une troisième électrode commune au transducteur (11) et au deuxième transducteur (13).

20. Procédé (400) d'intégration d'un système optoélectronique (1) avec un circuit de contrôle, le procédé comprenant :
- la fabrication du système optoélectronique (1) selon la revendication 11, en accomplissant les étapes (101-104; 201-205) du procédé de fabrication selon la revendication 14 ou 17 ;
- la formation (401) sur l'empilement d'un niveau de collage hybride comprenant une première électrode (117") en contact électrique avec première portion (116a) de la troisième couche (116), la première électrode (117") appartenant au transducteur (11), et une deuxième électrode (118") en contact électrique avec la troisième portion (116c) de la troisième couche (116), la deuxième électrode (118") appartenant au deuxième transducteur (13), les première et deuxième électrodes étant entourées d'une couche diélectrique (121), de manière à obtenir une surface plane avec les première (117") et deuxième (118") électrodes ;
- le collage (402) hybride de l'empilement avec un substrat récepteur (5) comprenant le circuit de contrôle (51), le circuit de contrôle comportant une pluralité de plots de connexion (511) entourés d'une couche diélectrique (52), de sorte que la première électrode et la deuxième électrode soient collées aux plots de connexion (511) du circuit de contrôle, et de sorte que la couche diélectrique de l'empilement soit collée à la couche diélectrique (52) du circuit de contrôle (51),
- le retrait (403) du substrat (14),
- la gravure (404) partielle:
∘ Au sein du transducteur (11) : de la première portion (111a) de la première couche (111) poreuse jusqu'à la deuxième couche (112), pour obtenir une première ouverture,
∘ Au sein du deuxième transducteur (13) : de la troisième portion (111c) de la première couche (111) poreuse jusqu'à la deuxième couche (112), pour obtenir une deuxième ouverture ;
- La formation (405) d'une troisième électrode (138") dans les première et deuxième ouvertures, la troisième électrode étant commune au transducteur (11) et au deuxième transducteur (12), et connexion de la troisième électrode (138") à l'un des plots de connexion du circuit de contrôle (51).
